# EUROPÄISCHE PATENTSCHRIFT

(11) **EP 1 776 849 B1**
(45) Veröffentlichungstag und Bekanntmachung des Hinweises auf die Patenterteilung: **11.01.2017**
(21) Anmeldenummer: 05758615.8
(22) Anmeldetag: 29.06.2005
(51) Int. Cl.: H05K 1/14

(54) **SCHNITTSTELLENBAUTSTEIN**
INTERFACE MODULE
INTERFACE DE MEMOIRE

(30) Priorität: 06.08.2004 DE 102004038591
(43) Veröffentlichungstag der Anmeldung: 25.04.2007
(73) Patentinhaber: ROBERT BOSCH GMBH, 70442 Stuttgart (DE)
(72) Erfinder: MOESSNER, Claus, 75228 Ispringen (DE); TRIESS, Burkhard, 71636 Ludwigsburg (DE); MAIER, Gert, 72770 Reutlingen (DE); BACH, Peter, 70193 Stuttgart (DE)
(86) Internationale Anmeldenummer: PCT/EP2005/053053
(87) Internationale Veröffentlichungsnummer: WO 2006/015907

(56) Entgegenhaltungen:
- US-A1- 2004 075 164
- PATENT ABSTRACTS OF JAPAN Bd. 2002, Nr. 09, 4. September 2002 (2002-09-04) -& JP 2002 141462 A (TOSHIBA CORP), 17. Mai 2002 (2002-05-17)
- PATENT ABSTRACTS OF JAPAN Bd. 2003, Nr. 03, 5. Mai 2003 (2003-05-05) -& JP 2002 324878 A (NEC CORP), 8. November 2002 (2002-11-08)

## Beschreibung

### Stand der Technik

Die Erfindung geht aus von einem Schnittstellenbaustein mit einem integrierten Bauelement gemäß dem Oberbegriff des unabhängigen Anspruchs.

Solche Schnittstellenbausteine werden in verschiedenen Anwendungen eingesetzt. Eine Möglichkeit ist z.B. einen Speicherbaustein eines Steuergerätes durch einen solchen Schnittstellenbaustein mit integriertem Bauelement zu ersetzen. Dabei wird dann der eigentliche Speicherbaustein, z.B. ein EPROM, EEPROM, Flash-Speicher, RAM, usw. durch einen Schnittstellenbaustein mit einem Ersatzspeicher ersetzt, z.B. durch mittels eines Emulator Tastkopfes (ETK). Solch ein Schnittstellenbaustein kann auch als Speicher-Interface bezeichnet werden. Durch dieses Speicher-Interface ist es möglich auf Speicherdaten eines Steuergerätes mittels eines Software-Tools über ein externes Gerät einen Tool-Rechner (z.B. ein PC) zuzugreifen und Mess- und Apllikationsanwendungen an dem Steuergerät durchzuführen.

Durch diesen Schnittstellenbaustein mit integriertem Bauelement können aber auch Microcontroller eines Steuergerätes selbst ersetzt werden, wobei es sich bei dem Bauelement dann eben um einen Microcontroller handelt. Im weiteren wird deshalb der Schnittstellenbaustein mit integriertem Bauelement als Microcontroller-Interface bezeichnet. Diese Bezeichnung ist aber nicht als Einschränkung bezüglich der Verwendung zu verstehen, wie die obigen Ausführungen belegen. Microcontroller-Interfaces sind nun insbesondere Vorrichtungen, die einem Software-Tool ermöglichen auf Signale von Microcontrollern (MCU) zuzugreifen. Der Microcontroller ist dabei am Einsatzort verbaut (z.B. in einem Steuergerät im Motorraum eines Kraftfahrzeuges)und sitzt dabei in der Regel auf einer Steuergeräteplatine oder Leiterplatte. Das Software-Tool wird auf einem externen Rechner, einem Tool-Rechner (beispielsweise einem PC) ausgeführt. Mit diesem Aufbau können verschiedene Tätigkeiten durchgeführt werden:
- Messen und Verstellen (Measurement & Calibration)
- Bypass-Anwendungen (Rapid-Prototyping)
- Fehlerbehebung sowie Funktions-und/oder Fehlerverfolgung

### (Debugging und Tracing)

JP 2002-141462 zeigt in den Figuren 4 und 7 eine Multilayer-Verpackung von mehreren Halbleiterelementen.

Stand der Technik ist dabei die Verwendung einer gedruckten Schaltung, die zwischen Steuergeräte-Platine und Microcontroller eingebaut wird. Dazu wird der Microcontroller vom Seriensteuergerät entfernt und durch einen Zwischensockel ersetzt. Auf diesen Zwischensockel wird das Microcontroller-Interface aufgesteckt, welches die zur Protokoll-Wandlung benötigten elektronischen Bauteile, den Zugang für das Software-Tool bzw. den Tool-Rechner (Stecker oder Kabel) und einen Microcontroller in einem Standard-Gehäuse enthält. Durch diesen Aufbau und die zusätzlichen elektronischen Bauteile ist die Grundfläche des Microcontroller-Interfaces, also des Schnittstellenbausteins deutlich größer als die Fläche des Microcontrollers selbst.

Dies stellt einen Nachteil da, da sich auf der Steuergeräte-Platine unter dem Schnittstellenbaustein also dem Microcontroller-Interface keine hohen Bauteile befinden dürfen. Außerdem muß darauf geachtet werden, dass der Schnittstellenbaustein nicht zu einer oder mehreren Seite über die Leiterplatten- oder Platinen-Grundfläche des Steuergerätes hinausragt. Tool-Hersteller und Steuergeräte-Hersteller müssen sich über die mechanischen Maße ihrer jeweiligen Produkte genau abstimmen. Dies ist schwierig, da sich insbesondere in der Anfangsphase der Steuergeräte-Entwicklung die Bauteile-Anordnung stark ändern kann. Trotzdem muß die Schnittstellenbaustein- oder Interface-Entwicklung möglichst früh gestartet werden, da das Microcontroller-Interface gleichzeitig mit dem Steuergerät verfügbar sein sollte.

Einen weiteren Nachteil stellt die monolithische Bauform dar. Der gesamte Schnittstellenbaustein mit integriertem Bauelement ist mit seiner Anpassung an den Einbauort und seiner Anspassung der. Signale zur Übertragung an den Tool-Rechner untrennbar in einer gedruckten Schaltung realisiert. Die Anpassung an den Einbauort ist jedoch abhängig von der mechanischen Bauform (z.B. Gehäuse) und vom Typ des Microcontrollers, während Anpassung der Signale von der durchgeführten Tätigkeit abhängt. Beim Messen und Verstellen muß beispielsweise auf andere Microcontroller-Funktionen und Schnittstellen zugegriffen werden als beim Debugging. Dadurch erhält man eine hohe Zahl von Schnittstellenbaustein- oder Interface-Varianten, die aufwendig herzustellen und zu verwalten sind.

So zeigt sich, dass der Stand der Technik nicht in jeder Hinsicht optimale Ergebnisse zu liefern vermag. Damit stellt sich die Aufgabe einen Schnittstellenbaustein darzustellen, der zum einen eine hohe Flexibilität bezüglich des Einbauortes aufweist und zum anderen die Anzahl der Varianten begrenzen kann.

### Vorteile der Erfindung

Die Erfindung geht aus von einem Schnittstellenbaustein mit einem integrierten Bauelement, zum Ersatz eines Bauelementes auf einer Platine, wobei bei dem Schnittstellenbaustein an der Unterseite die Anschlusskontakte derart ausgebildet sind, wie für die Kontakte des Bauelementes auf der Platine vorgesehen, wobei der Schnittstellenbaustein vorteilhafter Weise in einen Adaptierungsteil als Basis-Modul und einen Protokollwandlerteil als Tool-Zugriffs-Modul aufgeteilt ist, das Basis-Modul aus einem Adaptierungssockel und einem Trägersubstrat gebildet wird, das Trägersubstrat auf der Unterseite die Anschlusskontakte besitzt, und wobei über Verbindungen im Trägersubstrat die Adaptierungskontakte des auf dem Trägersubstrat angeordneten Bauelements mit den Anschlusskontakten verbunden sind, und durch den Adaptierungssockel alle für die Adaptierung notwendigen Signale des Bauelements auf die Oberseite des Basismoduls geführt werden. Das Basis-Modul und das Tool-Zugriffs-Modul sind über Steckkontakte und Steckbuchsen verbunden, und das Tool-Zugriffs-Modul weist elektronische Bauteile zur Protokollwandlung von lokalen Mikrocontroller-Bussen in übertragungsfähige Protokolle auf.

Zweckmäßiger Weise ist das das integrierte Bauelement (1) in dem Basis-Modul in Chip-Scale-Package Technik integriert wodurch eine kleinere Verpackung möglich ist.

Weiterhin vorteilhaft ist, dass das integrierte Bauelement im Basis-Modul enhalten ist und das Basis-Modul einen Adaptierungssockel enhält, wobei das integrierte Bauteil und der Adaptierungssockel als Ball-Grid-Array (BGA) ausgeführt sind.

Zweckmäßiger Weise wird das Basis-Modul aus einem Adaptierungssockel und einem Trägersubstrat gebildet wird, wobei der Adaptierungssockel Adaptierungskontakte enthält und das Trägersubstrat die Anschlusskontakte besitzt, wobei über Verbindungen, insbesondere Leitungen, im Trägersubstrat die Adaptierungskontakte (mit den Anschlußkontakten verbunden sind, wodurch eine sehr flexible Anspassung an diverse Anschlußvarianten erfolgen kann.

Vorteilhafter Weise wird das Tool-Zugriffs-Modul aus einem Modulsubstrat und einem Adapter gebildet, wobei das Modulsubstrat und der Adapter über Adapter-Substrat-Kontakte verbunden sind.

Weiterhin von Vorteil ist, dass das Basis-Modul und das Tool-Zugriffs-Modul über Steckkontakte und Steckbuchsen verbunden sind, wobei der Adaptierungssockel die Steckbuchsen und der Adapter die Steckkontakte aufweist.

In einem ersten Ausführungsform ist das integreirte Bauelement ein Microcontroller, was auch Prozessoren, insbesondere auch spezielle Prozessoren wie Signalprozessoren (DSP) usw, oder sonstige intelligente Bauteile umfasst.

In einem zweiten Ausführungsbeispiel ist das integrierte Bauelement ein Speicherbaustein, was insbesondere alle programmierbaren Speicher wie EPROM, PROM, RAM, EEPROM, Flash-Speicher usw. umfasst.

Der erfindungsgemäße Schnittstellenbaustein bzw. das Microcontroller-Interface hat somit den Vorteil, dass das Interface nahezu die gleiche bzw. exakt die gleiche Grundfläche wie das Bauelement, z.B. der Microcontroller besitzt, das es ersetzt. Dadurch vereinfacht sich die Abstimmung zwischen Tool-Hersteller und Steuergeräte-Hersteller signifikant. Der Steuergeräte-Hersteller ist keiner Beschränkung bezüglich Platinen-Layout unterworfen. Es können beliebig hohe Bauteile direkt neben dem Microcontroller platziert werden.

Außerdem wird durch die physikalische Trennung von Adaptierungsteil und Protokollwandler-Teil die Variantenvielfalt insbesondere von benötigten Microcontrollern stark eingeschränkt. Durch Schnittstellenbausteine mit standardisiertem Adaptionsteil bzw. Schnittstelle kann die Anzahl von herzustellenden Produkten reduziert und die Verwaltung und Wartung vereinfacht werden. Für jede Kombination aus Microcontroller und ausgeführter Tätigkeit kann somit eine ideale Kombination aus Adaptionsteil und Protokollwandler zur Verfügung gestellt werden. Hierbei können die Module von unterschiedlichen Anbietern geliefert werden. Die Module sind
über emechanisch zuverlässige und Automobil-taugliche Kontakte verbunden.

### Zeichnung

Ein Ausführungsbeispiel der Erfindung ist in der Zeichnung dargestellt und wird in der nachfolgenden Beschreibung näher erläutert. Die Zeichnung besteht aus unterschiedlichen Ansichten eines stark vereinfachten, nicht maßstäblichen Ausführungsbeispiels des erfindungsgemäßen Schnittstellenbausteins inspesonder Microcontroller-Interfaces oder Speicher-Inerfaces. Das Interface besteht aus zwei physikalisch getrennten Modulen, die mittels Kontakten aufeinander gesteckt werden können: Das Basis-Modul (gekennzeichnet mit den Ziffern 1 bis 8) realisiert den Adaptierungs-Teil, während das Tool-Zugriff-Modul (gekennzeichnet mit den Buchstaben A bis E) den Protokollteil realisiert.

Dabei zeigt
Figur 1 eine Draufsicht auf das Basisi-Modul.
Figur 2 offenbart eine Seitenansicht des Tool-Zugriffsmoduls.
Figur 3 zeigt Seitenansichten unterschiedlicher Tiefe bezüglich des Basis-Moduls.
Figur 4 schließlich zeigt den Schnittstellenbaustein bzw. das Basis-Modul von unten.

Die Erfindung wird nachfolgend anhand der Ausführungsbeispiele näher erläutert.

### Beschreibung der Ausführungsbeispiele

Erfindungsgemäß wird das Microcontroller-Interfaces in zwei logischen Teilen betrachtet:
1) Einem Adapterierungsteil, der die benötigten Ein/Ausgabe-Pins (I/O-Pins) des Microcontrollers kontaktiert.
2) Einem Protokollwandler, der die MCU-Signale so umsetzt, dass sie über längere Entfernungen sicher und zuverlässig übertragen werden können.

Im Stand der Technik ist dies in monolithischer Bauform realisiert. Adaptierungsteil und Protokollwandler sind untrennbar in einer gedruckten Schaltung realisiert. Der Adaptierungsteil ist jedoch abhängig von der mechanischen Bauform (z.B. Gehäuse) und vom Typ des Microcontrollers, während der Protokollwandler von der durchgeführten Tätigkeit abhängt. Dadurch erhält man eine hohe Zahl von Interface-Varianten im Stand der Technik, die aufwendig herzustellen und zu verwalten sind. Dies wird durch die erfindungsgemäße physikalische Trennung in einen Adaptierungsteil als Basis-Modul (100) und einen Protokollwandlerteil als Tool-Zugriffs-Modul (200) beherrscht und verbessert.

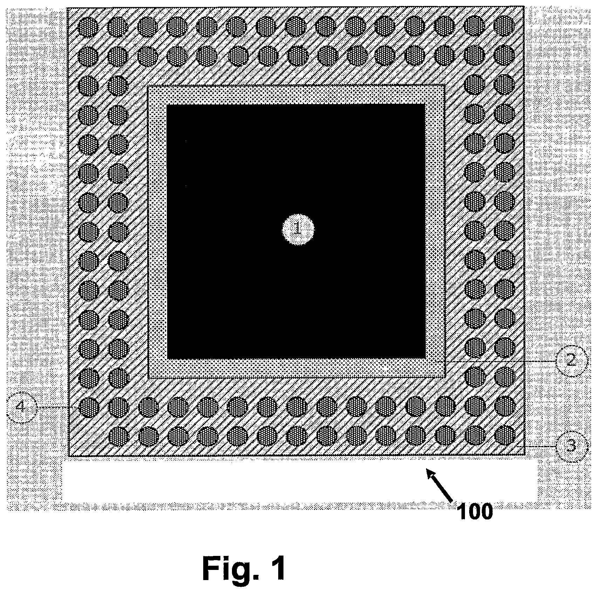

In Figur 1 ist das Ausführungsbeispiel des Basis-Modules 100 des erfindungsgemäßen Schnittstellenbausteins als Microcontroller-Interface oder Speicher-Interface in der Ansicht von oben gezeigt. In dem hier gezeigten Ausführungsbeispiel bildet der Adaptierungssockel 3 den Rahmen des Basis-Modules 100. Es handelt sich um einen BGA-Sockel (Ball-Grid-Array) mit zweireihigen Kontakten auf allen vier Seiten. Zur Kodierung gegen Verdrehung fehlt ein Eckpin des Adaptierungssockels 3.

Im Freiraum des Adaptierungssockels sitzt das integrierte Bauelement 1, insbesondere der Microcontroller oder der Speicherbaustein. Dabei ist das Bauelement, insbesondere der Microcontroller, als Chip-Scale-Package (CSP) realisiert. Dabei handelt es sich um einen stark verkleinertes Gehäuse, welches den gleichen Chip-Die (inneres Chip-Substrat, Mikro-Plättchen) enthält wie das Standard-Gehäuse, allerdings ein dichteres Kontakt-Layout, einen kleineren Pitch besitzt. Dadurch ist es möglich, die gleiche Microcontroller-Funktionalität in kleinerer Verpackung zu erreichen.

Der Adaptierungssockel 3 und der Microcontroller als integreirtes Bauelement 1 sind als Ball-Grid-Array (BGA) ausgeführt und auf ein Trägersubstrat 2 aufgelötet. Alternativ könnte auch eine Klebeverfahren zum Einsatz kommen.

Alle für die Adaptierung notwendigen Microcontroller-Signale sind über Steckbuchsen 4 des Adaptierungssockels 3 von oben zugänglich.

Durch den beschriebenen Aufbau erhält man ein Basis-Modul 100 mit der gleichen Grundfläche und dem gleichen Pinout, also der gleichen Anschlusskontaktanordnung wie das Standard Bauelement, also der Standard-Microcontroller oder Standard Speicher, der normalerweise, insbeonder in der Serie, eingesetzt wird und erfindungsgenmäß ersetzt werden soll.

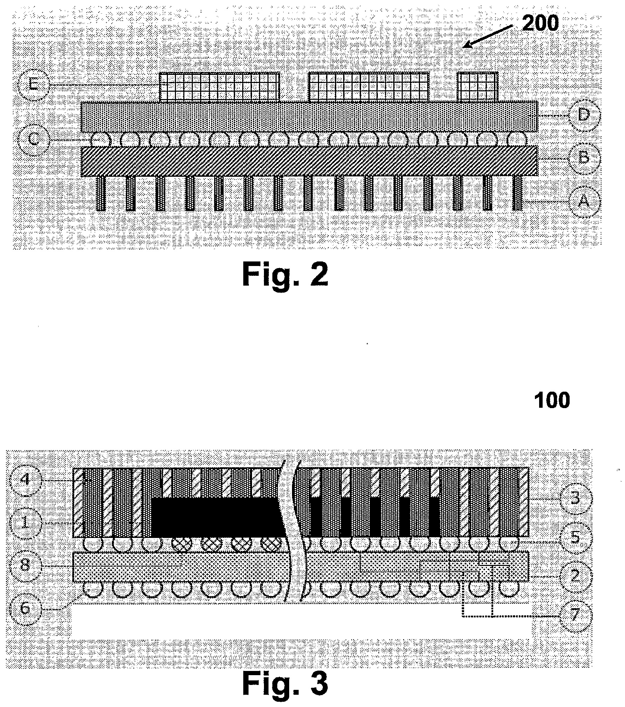

Figur 2 und 3 zeigt das Ausführungsbeispiel des erfindungsgemäßen Schnittstellenbausteins bzw. Microcontroller-Interfaces von der Seite. Wobei Figur 3 das Basis-Modul und Figur 2 das Tool-Zugriffs-Modul zeigt.

Bei Figur 3 zeigt in der Hälfe links der Wellenlinie ein Schnittbild durch das Bauelement, den Microcontroller selbst, also das innere des Basis-Moduls und die Hälfe rechts der Wellenlinie zeigt die Seitenansicht als Aufsicht von außen auf das Basis-Modul 100.

In Figur 3 ist das Bauelement, also der Microcontroller 1 mit seinen Adaptierungskontakten 8, insbesondere als BGA-Kontakte ausgeführt, auf das Trägersubstrat 2 aufgelötet (oder anderweitig verbunden) und wird von der Vorderseite des Adaptierungssockels 3 verdeckt. Der Adaptierungssockel 3 ist über Sockel-Kontakte 5 ebenfalls auf das Trägersubstrat 2 aufgelötet (oder anderweitig verbunden). An der Unterseite des Trägersubstrates 2 sind die Kontakte des Basis-Moduls 100 angebracht, die dem Pinout des Microcontrollers im Standard-Gehäuse entsprechen. Über Verbindungen, insbesondere Leitungen 7 im Trägersubstrat wird ein Kontakt zwischen diesen Kontakten 6 und den Kontakten an der Oberseite für Microcontroller, den Adaptierungskontakten 8 aus den Sockel-Kontakten 5 hergestellt. Dadurch ist eine Anpassung unterschiedlichster Bauelemente an unetrscheidlichste Kontaktstellen problemlos möglich.

Damit ist ein Schnittstellenbaustein, insbesondere in Leiterplattentechnik, mit einem IC-Bauelement 1 im Chip-Scale-Package und einem umgebenden Adaptierungssockel 3 gezeigt, wobei der Schnittstellenbaustein von unten das Pinout 6 des IC-Bauelements im Standard-Gehäuse besitzt und im Trägersubstrat 2 alle IC-Signale zwischen Chip-Scale-Package-Kontakten oder Adaptierungskontakten 8 und Modul-Anschlusskontakten 6 korrekt und vollständig verdrahtet sind und alle zur Adaptierung notwendigen Signale auf die oberste Lage des Trägersubstrats 2 geführt werden und mit den Kontakten 5 des AdaptierungsSockels 3 verbunden sind und an Kontakt- oder Steckbuchsenbuchsen 4 an der Oberseite des Basis-Modules 100 zur Verfügung stehen.

In Figur 2 ist das Tool-Zugriffs-Modul 200 gezeigt, welches auf das Basis-Modul 100 aufgesteckt werden kann. Dieses Tool-Zugriffs-Modul 200 besteht aus einem Modul-Substrat D mit elektronischen Bauteilen E, welche unten mit einem Adapter B über Adapter-Substrat-Kontakte C verbunden sind.

Steckkontakte A des Tool-Zugriff-Moduls 200 stellen die Verbindung zu den Steckbuchsen 4 des Basis-Moduls her. Damit ist beispielhaft ein Modul-Substrat D, insbesondere in Leiterplattentechnik, gezeigt mit einem oder mehreren aufgelöteten oder aufgeklebten elekronischen Bauteilen E, welche auf einen (BGA)-Adapter B aufgelötet oder aufgeklebt wird, der mittels Steckkontakten A auf die Kontakt- oder Steckbuchsen 4 des Basis-Modules 100 verbunden werden kann. Dabei dienen die die elektronischen Bauteile E insbesondere zur Protokollwandlung von lokalen Microcontroller-Bussen in übertragungsfähige Protokolle. Als Microcontroller-Bus kommen z.B. JTAG, Nexus oder AUD zum Einsatz oder auch der lokale Adress-, Daten- und Kontroll-Bus. Dabei dienen die genannten Busse z.B. zum Anschluß eines Kalibrierungs-RAMs, wobei das Kalibrierungs-RAM insbesondere als ein Dual-Ported-RAM ausgebildet ist. Das übertragungsfähige Protokoll ist dabei insbesondere als 100 MBit/s-Ethernet nach IEEE 802.3 ausgeführt ist. Zweckmäßig kommt auch ein Protokoll nach IEEE 802.3u (100 MBit/s) zum Einsatz oder nach IEEE 802.ab (1 GBit/s).

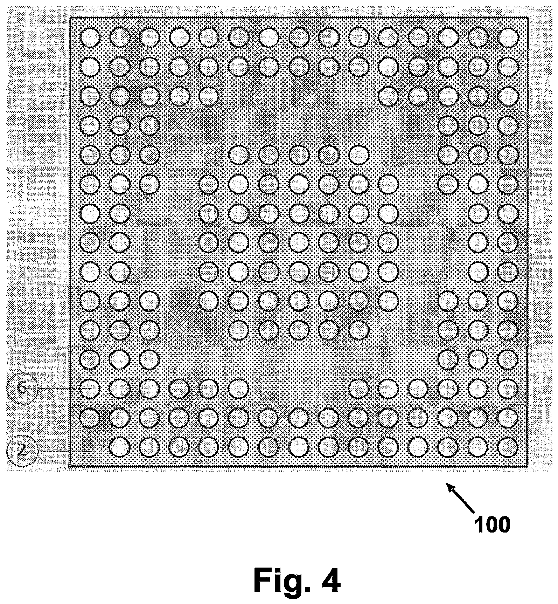

Figur 4 schließlich zeigt das gleiche Ausführungsbeispiel des erfindungsgemäßen Schnittstellenbausteins bzw. Microcontroller-Interfaces oder Speicher-Interfaces von unten.

Das Trägersubstrat 2 des Basis-Modules 100 hat wie bereist erwähnt das gleiche Pinout, also die gleichen Kontakte 6 und nahezu die gleiche oder exakt die gleiche Fläche, wie das Standard-Gehäuse des Bauelementes, insbesondere des Microcontrollers. Das Basis-Modul wird über die Anschluß-Kontakte 6 mit der Leiterplatte oder Platine, insbesondere des Steuergerätes verbunden.

## Patentansprüche

1. Schnittstellenbaustein mit einem integrierten Bauelement, zum Ersatz eines Bauelementes auf einer Platine, wobei bei dem Schnittstellenbaustein an der Unterseite Anschlusskontakte (6) derart ausgebildet sind, wie für die Kontakte des Bauelementes auf der Platine vorgesehen, und wobei der Schnittstellenbaustein in einen Adaptierungsteil als Basis-Modul (100) und einen Protokollwandlerteil als Tool-Zugriffs-Modul (200) aufgeteilt **dadurch gekennzeichnet dass** das Basis-Modul aus einem Adaptierungssockel (3) und einem Trägersubstrat (2) gebildet wird, dass das Trägersubstrat (2) auf der Unterseite die Anschlusskontakte (6) besitzt, wobei über Verbindungen (7) im Trägersubstrat (2) die Adaptierungskontakte (8) des auf dem Trägersubstrat angeordneten Bauelements mit den Anschlusskontakten (6) verbunden sind, und dass durch den Adaptierungssockel (3) alle für die Adaptierung notwendigen Signale des Bauelements auf die Oberseite des Basismoduls (100) geführt werden, dass das Basis-Modul (100) und das Tool-Zugriffs-Modul (200) über Steckkontakte (A) und Steckbuchsen (4) verbunden sind, und dass das Tool-Zugriffs-Modul (200) elektronische Bauteile zur Protokollwandlung von lokalen Mikrocontroller-Bussen in übertragungsfähige Protokolle aufweist.

2. Schnittellenbaustein nach Anspruch 1, **dadurch gekennzeichnet, dass** das integrierte Bauelement (1) in dem Basis-Modul in Chip-Scale-Package Technik integriert ist.

3. Schnittellenbaustein nach Anspruch 1, **dadurch gekennzeichnet, dass** das integrierte Bauteil (1) und der Adaptierungssockel (3) als Ball-Grid-Array (BGA) ausgeführt sind.

4. Schnittstellenbaustein nach Anspruch 1, **dadurch gekennzeichnet, dass** das Tool-Zugriffs-Modul aus einem Modulsubstrat (D) und einem Adapter (B) gebildet wird.

5. Schnittstellenbaustein nach Anspruch 4, **dadurch gekennzeichnet, dass** das Modulsubstrat (D) und der Adapter (B) über Adapter-Substrat-Kontakte (C) verbunden sind.

6. Schnittellenbaustein nach Anspruch 1, **dadurch gekennzeichnet, dass** das Basis-Modul (100) die Steckbuchsen (4) aufweist und das Tool-Zugriffs-Modul (200) einen Adapter (B) enthält, der seinerseits die Steckkontakte (A) aufweist.

7. Schnittstellenbaustein nach Anspruch 1, **dadurch gekennzeichnet, dass** das integrierte Bauelement (1) ein Mikrocontroller ist.

8. Schnittstellenbaustein nach Anspruch 1, **dadurch gekennzeichnet, dass** das integrierte Bauelement (1) ein Speicherbaustein ist.

9. Schnittstellenbaustein nach Anspruch 8, **dadurch gekennzeichnet, dass** der Speicherbaustein programmierbar ist.

## Claims

1. Interface module having an integrated component for replacing a component on a printed circuit board, connection contacts (6) being formed on the underside of the interface module in the manner provided for the contacts of the component on the printed circuit board, and the interface module being divided into an adaptation part as a basic module (100) and a protocol converter part as a tool access module (200), **characterized in that** the basic module is formed from an adaptation base (3) and a carrier substrate (2), **in that** the carrier substrate (2) has the connection contacts (6) on the underside, the adaptation contacts (8) of the component arranged on the carrier substrate being connected to the connection contacts (6) via connections (7) in the carrier substrate (2), and **in that** all signals from the component which are required for the adaptation are guided through the adaptation base (3) to the top side of the basic module (100), **in that** the basic module (100) and the tool access module (200) are connected via plug contacts (A) and plug sockets (4), and **in that** the tool access module (200) has electronic component parts for the protocol conversion of local microcontroller buses into protocols which can be transmitted.

2. Interface module according to Claim 1, **characterized in that** the integrated component (1) in the basic module is integrated using chip scale package technology.

3. Interface module according to Claim 1, **characterized in that** the integrated component part (1) and the adaptation base (3) are in the form of a ball grid array (BGA).

4. Interface module according to Claim 1, **characterized in that** the tool access module is formed from a module substrate (D) and an adapter (B).

5. Interface module according to Claim 4, **characterized in that** the module substrate (D) and the adapter (B) are connected via adapter substrate contacts (C).

6. Interface module according to Claim 1, **characterized in that** the basic module (100) has the plug sockets (4) and the tool access module (200) contains an adapter (B) which in turn has the plug contacts (A).

7. Interface module according to Claim 1, **characterized in that** the integrated component (1) is a microcontroller.

8. Interface module according to Claim 1, **characterized in that** the integrated component (1) is a memory module.

9. Interface module according to Claim 8, **characterized in that** the memory module is programmable.

## Revendications

1. Sous-ensemble d'interface comprenant un élément structural intégré, destiné à remplacer un élément structural sur une platine, des contacts de raccordement (6) étant configurés sur le côté inférieur du sous-ensemble d'interface de la même manière qu'ils sont prévus pour les contacts de l'élément structural sur la platine, et le sous-ensemble d'interface étant divisé en une partie d'adaptation faisant office de module de base (100) et une partie convertisseur de protocole faisant office de module d'accès d'outil (200),
**caractérisé en ce**
**que** le module de base est constitué d'un socle d'adaptation (3) et d'un substrat porteur (2), en ce que le substrat porteur (2) possède les contacts de raccordement (6) sur le côté inférieur, les contacts d'adaptation (8) de l'élément structural disposé sur le substrat porteur étant reliés aux contacts de raccordement (6) par le biais de liaisons (7) dans le substrat porteur (2), et en ce que tous les signaux de l'élément structural nécessaires à l'adaptation sont acheminés sur le côté supérieur du module de base (100) à travers le socle d'adaptation (3), en ce que le module de base (100) et le module d'accès d'outil (200) sont reliés par le biais de contacts d'enfichage (A) et de douilles d'enfichage (4), et en ce que le module d'accès d'outil (200) possède des composants électroniques servant à la conversion de protocole des bus de contrôleur locaux en des protocoles aptes à la transmission.

2. Sous-ensemble d'interface selon la revendication 1, **caractérisé en ce que** l'élément structural intégré (1) est intégré sur le module de base en technologie de boîtier à puce.

3. Sous-ensemble d'interface selon la revendication 1, **caractérisé en ce que** l'élément structural intégré (1) et le socle d'adaptation (3) sont réalisés sous la forme d'un boîtier matriciel à billes (BGA).

4. Sous-ensemble d'interface selon la revendication 1, **caractérisé en ce que** le module d'accès d'outil est constitué d'un substrat de module (D) et d'un adaptateur (B).

5. Sous-ensemble d'interface selon la revendication 4, **caractérisé en ce que** le substrat de module (D) et l'adaptateur (B) sont reliés par le biais de contacts adaptateur-substrat (C).

6. Sous-ensemble d'interface selon la revendication 1, **caractérisé en ce que** le module de base (100) possède les douilles d'enfichage (4) et le module d'accès d'outil (200) contient un adaptateur (B) qui possède de son côté les contacts d'enfichage (A).

7. Sous-ensemble d'interface selon la revendication 1, **caractérisé en ce que** l'élément structural intégré (1) est un microcontrôleur.

8. Sous-ensemble d'interface selon la revendication 1, **caractérisé en ce que** l'élément structural intégré (1) est un sous-ensemble de mémoire.

9. Sous-ensemble d'interface selon la revendication 8, **caractérisé en ce que** le sous-ensemble de mémoire est programmable.
